# EUROPÄISCHE PATENTANMELDUNG

(11) **EP 2 161 653 A2**
(43) Veröffentlichungstag der Anmeldung: **10.03.2010**
(21) Anmeldenummer: 09179657.3
(22) Anmeldetag: 18.08.2006
(51) Int. Cl.: G06F 3/044

(54) **Kapazitiver Stellstreifen und Haushaltsgerät mit einem solchen**

(30) Priorität: 30.08.2005 DE 102005041114
(62) Teilanmeldung aus: 06778279.7
(71) Anmelder: BSH Bosch und Siemens Hausgeräte GmbH, 81739 München (DE)
(72) Erfinder: Großer, Jörg, 93077 Bad Abbach (DE); Klopfer, Wilfried, 93057 Regensburg (DE); Reinker, Bernward Maria, 93128 Regenstauf (DE); Romanowski, Hans-Jürgen, 93170 Bernhardswald (DE)

(57) **Zusammenfassung**

Die Erfindung bezieht sich auf einen kapazitiven Stellstreifen, der zumindest eine von einem Dielektrikum (2) abgedeckte elektrisch leitfähige Sensorfläche (6) aufweist, die Teil eines Kondensators (51, 52) mit durch Berührung des Stellstreifens (3) innerhalb eines Betätigungsbereichs (23) veränderlicher Kapazität ist, wobei eine Kapazitätsänderung des Kondensators (51, 52) bei Berührung innerhalb des Betätigungsbereichs (23) von der Berührungsposition (20) längs des Stellstreifens (3) abhängig ist und auf ein Haushaltsgerät mit solch einem kapazitiven Stellstreifen (3). Längs des Stellstreifens (3) sind galvanisch isoliert zu der Sensorfläche (6) und galvanisch isoliert zueinander eine Vielzahl von elektrisch leitfähigen Querstreifen (211 bis 219) nebeneinander angeordnet, die zumindest die Sensorfläche (6) in ihrer Ausdehnung quer zu dem Stellstreifen (3) überdecken.

## Beschreibung

Die Erfindung bezieht sich auf einen kapazitiven Stellstreifen, der zumindest eine von einem Dielektrikum abgedeckte elektrisch leitfähige Sensorfläche aufweist, die Teil eines Kondensators mit durch Berührung des Stellstreifens innerhalb eines Betätigungsbereichs veränderlicher Kapazität ist, wobei eine Kapazitätsänderung des Kondensators bei Berührung innerhalb des Betätigungsbereichs von der Berührungsposition längs des Stellstreifens abhängig ist und auf ein Haushaltsgerät mit solch einem kapazitiven Stellstreifen.

Es sind bereits zahlreiche Vorrichtungen mit kapazitiven Sensoren oder Schaltern bekannt. Bei einer speziellen Bauart dieser kapazitiven Sensoren, ist eine elektrisch leitende Sensorfläche von einer elektrisch isolierenden Abdeckplatte abgedeckt. Ein Benutzer berührt also die Sensorfläche nicht direkt, sondern nähert sich ihr bei Berührung der Abdeckplatte lediglich an. Die Sensorfläche bildet eine Elektrode eines offenen Kondensators, dessen Kapazität sich auf ein Bezugspotenzial in großer Distanz bezieht (z.B. Erde). Durch Annäherung eines Fingers des Benutzers wird der Abstand zu diesem Bezugspotenzial und damit die Kapazität des Kondensators verändert.

Die vorliegende Erfindung bezieht sich auf eine spezielle Bauart von kapazitiv wirkenden Schaltern, bei der sich die elektrisch leitende Sensorfläche entlang der geometrischen Form eines Stellstreifens erstreckt. Bei Berührung des Stellstreifens innerhalb seines Betätigungsbereichs ist die Kapazitätsänderung des mit der Sensorfläche gebildeten Kondensators von der Berührposition längs des Stellstreifens abhängig. Auf diese Weise können verschiedenen Bereichen des Stellstreifens verschiedene Stellwerte zugeordnet sein, die durch Berührung des jeweiligen Bereichs bzw. Gleiten entlang des Stellstreifens eingestellt werden können.

Ein solcher kapazitiver Stellstreifen ist bereits aus US 6 879 930 B2 bekannt. Dort sind mehrere dreieckförmige Sensorflächen, die sich jeweils längs des Stellstreifens erstrecken, quer zum Stellstreifen nebeneinander angeordnet. Ein solcher Stellstreifen hat allerdings den Nachteil, dass bei ungenauer Berührposition quer zur Ausdehnungsrichtung des Stellstreifens ein fehlerhaftes Stellergebnis erzielt wird. Um solch eine Ungenauigkeit bei der Berührposition zu vermeiden, wird in US 6 879 930 B2 längs des Stellstreifens eine Mulde in die Abdeckplatte geformt, so dass für den Benutzer die Berührposition quer zum Stellstreifen eindeutig vorgegeben ist. Dieses Vorgehen hat allerdings den Nachteil, dass die Abdeckplatte eine Mindestmaterialdicke aufweisen muss, bei der solch eine Vertiefung ausgebildet werden kann, wodurch der Anwendungsbereich des Stellstreifens eingeschränkt ist. Darüber hinaus erhöht die Ausbildung der Vertiefung den Aufwand bei der Fertigung der Abdeckplatte, wodurch sich die Herstellung insgesamt verteuert.

Der vorliegenden Erfindung liegt daher die Aufgabe zugrunde, einen verbesserten, kostengünstigen kapazitiven Stellstreifen zur Verfügung zu stellen.

Gelöst wird die vorstehend aufgezeigte Aufgabe durch einen kapazitiven Stellstreifen mit den Merkmalen des Anspruchs 1. Vorteilhafte sowie bevorzugte Ausgestaltungen der Erfindung sind Gegenstand der abhängigen Ansprüche.

Bei einem kapazitiven Stellstreifen der eingangs genannten Art, ist zumindest eine elektrisch leitfähige Sensorfläche von einem Dielektrikum abgedeckt und bildet nach einem bekannten Prinzip eine Fläche eines Kondensators, dessen Kapazität durch Annäherung bzw. Berührung des Dielektrikums innerhalb eines Betätigungsbereichs des Stellstreifens veränderlich ist. Dabei ist diese Kapazitätsänderung des Kondensators bei Berührung innerhalb des Betätigungsbereichs abhängig von der Berührposition längs des Stellstreifens, was mittels einer Auswerteschaltung bekannter Art ausgewertet werden kann. D.h. das Dielektrikum dient als Berühr- oder Annäherungsfläche des kapazitiven Stellstreifens, wobei abhängig von der Position einer Berührung des Dielektrikums längs des Stellstreifens jeweils ein dieser Position zugeordneter Stellwert eingestellt werden kann. Das Dielektrikum kann beispielsweise eine elektrisch isolierende Abdeckplatte sein, wie beispielsweise eine Bedienblende aus Kunststoff oder ein Glaskeramikkochfeld. Längs des Stellstreifens sind galvanisch isoliert zu der Sensorfläche und galvanisch isoliert zueinander eine Vielzahl von elektrisch leitfähigen Querstreifen nebeneinander angeordnet, die zumindest die Sensorfläche in ihrer Ausdehnung quer zu dem Stellstreifen überdecken. Durch diese elektrisch leitfähigen Querstreifen kann eine Ungenauigkeit der Berührposition quer zum Stellstreifen ausgeglichen werden, da eine Berührung des Stellstreifens im Bereich der Querstreifen eine Ladungsträgerverschiebung in den Querstreifen hervorruft, die den Effekt der Berührung an die Position der Sensorfläche überträgt. Die Querstreifen können dabei in Bezug auf das Dielektrikum entweder auf derselben Seite wie die Sensorfläche oder auf der der Sensorfläche abgewandten Seite angeordnet sein.

Bevorzugt sind die Querstreifen längs des Stellstreifens äquidistant angeordnet und weisen insbesondere einheitliche Abmessungen auf. Auf diese Weise ist der Einfluss der Querstreifen auf die Bestimmung der Kapazitätsänderungen und damit auf die Sensitivität über den gesamten Stellstreifen gleich. Es ist alternativ auch möglich durch gezielte Änderung der Abstände bzw. der Abmessungen, insbesondere der Breiten, von aufeinanderfolgenden Querstreifen die Sensitivität längs des Stellstreifens zu variieren. Der Stellstreifen kann verschiedenen geometrischen Kurven folgen, wie beispielsweise geradlinig, gebogen oder ringförmig. Bei einem gebogenen bzw. ringförmigen Stellstreifen verlaufen die erfindungsgemäßen Querstreifen bevorzugt senkrecht zur Krümmung, d.h. in radialer Richtung, und können insbesondere trapezförmig ausgebildet sein. Bei einem Stellstreifen, der eine Betätigungsgerade aufweist, stehen die erfindungsgemäßen Querstreifen bevorzugt senkrecht auf dieser Betätigungsgeraden. Die Breite der einzelnen Querstreifen kann entsprechend einer gewünschten Stellwerteinteilung gewählt werden. Vorzugsweise werden bei Berührung des Stellstreifens mehrere nebeneinanderliegende Querstreifen zumindest teilweise überdeckt.

Zur Funktionsprüfung des Stellstreifens kann zumindest einer der Querstreifen als ein Testquerstreifen ausgebildet sein, der zum Anlegen von Massepotenzial mit Masse verbindbar ist. Alternativ dazu kann zwischen den Querstreifen zumindest ein zusätzlicher Testquerstreifen vorgesehen sein, der insbesondere unterschiedlich zu den Querstreifen ausgebildet sein kann, und der zum Anlegen von Massepotenzial mit Masse verbindbar ist. Beispielsweise ist der Testquerstreifen zumindest zweimal so breit wie einer der Querstreifen ausgebildet, so dass die Sensitivität des Stellstreifens im Bereich des Testquerstreifens erhöht ist. Unter Masse wird hier ein festes Potenzial, wie beispielsweise Erdpotenzial oder ein Bezugspotenzial der Auswerteschaltung des Stellstreifens verstanden. Um einen Referenzwert der Auswerteschaltung des Stellstreifens zu ermitteln, kann an den Testquerstreifen Massepotenzial gelegt werden, wodurch eine Betätigung des Stellstreifens im Bereich des Testquerstreifens simuliert wird. Dadurch kann überprüft werden, ob ein ausreichender Signalhub eines Ausgangssignals in der Auswerteschaltung vorliegt, welches die Betätigung des Stellstreifens angibt, oder ob eventuell aufgrund von Verunreinigungen oder Benetzung des Dielektrikums bzw. der Abdeckplatte oder aufgrund von Alterungsprozessen des Stellstreifens eine Fehlfunktion vorliegt. Auf diese Weise können Fehlbedienungen des Stellstreifens vermieden werden, wodurch die Funktionssicherheit des Stellstreifens verbessert wird. Insbesondere kann ein mit dem erfindungsgemäßen Stellstreifen ausgestattetes Gerät automatisch abgeschaltet werden, wenn eine sichere Funktion des Stellstreifens nicht mehr gewährleistet ist, bzw. es kann über eine eventuell vorhandene Anzeigeeinrichtung signalisiert werden, dass eine Fehlfunktion vorliegt. Vorteilhafterweise kann der Signalhub des Ausgangssignals dynamisch angepasst und der Stellstreifen dadurch automatisch kalibriert werden.

Aus US 6 879 930 B2 ist bekannt, kapazitive Stellstreifen mit zumindest einer Sensorfläche auszubilden, die längs des Stellstreifens eine variierende Breite aufweist. Alternativ dazu kann die Sensorfläche durch zumindest zwei voneinander galvanisch isolierte Teilflächen gebildet sein, die jeweils längs des Stellstreifens eine variierende Breite aufweisen. Bei einem geradlinigen Stellstreifen liegen sich die beiden Teilflächen vorzugsweise derart gegenüber, dass durch sie eine rechteckige Sensorfläche gebildet wird. Zum Beispiel sind die Teilflächen, insbesondere rechtwinklige, Dreiecksflächen, die sich mit ihrer jeweiligen Hypotenuse gegenüberliegen.

Bei einem Stellstreifen, der keine geschlossene Kurve, wie beispielsweise einen Ring bildet, sondern zwei Enden aufweist, ist die Erkennung bei Berührung der Endpositionen des Stellstreifens problematisch, da ähnliche Ausgangssignale wie an anderen Berührpositionen des Stellstreifens auftreten können. Deswegen ist erfindungsgemäß zumindest an einem Ende des Stellstreifens benachbart zu der Sensorfläche eine Endsensorfläche angeordnet, so dass eine Berührung dieser Endposition des Stellstreifens eindeutig erkannt werden kann. Es ist aus US 6 879 930 B2 bekannt, bei einem geradlinigen Stellstreifen benachbart zu dessen Enden zusätzlich Sensortasten anzuordnen, durch die zusätzliche Funktionen geschaltet werden können. Erfindungsgemäß kann die Endsensorfläche des Stellstreifens derart ausgebildet sein, dass sie zusammen mit der Sensorfläche einer benachbart angeordneten Sensortaste eine einheitliche, elektrisch leitfähige Fläche bildet. Eine Auswertung, ob eine Berührung in dem gemeinsamen Bereich der Endsensorfläche und der Sensorfläche der benachbart angeordneten Sensortaste eine Einstellung eines Stellwertes des Stellstreifens oder eine Schaltung der Sensortaste bezweckt, erfolgt per Softwareprogramm, beispielsweise in einem Mikroprozessor einer gemeinsamen Auswerteschaltung des Stellstreifens und der Sensortaste.

Um bei einer Berührung des Stellstreifens sicher einen Endzeitpunkt bzw. einen Anfangszeitpunkt der Berührung des Stellstreifens erkennen zu können, ist erfindungsgemäß längs des Stellstreifens, insbesondere parallel zu der Sensorfläche, eine Abhebesensorfläche angeordnet, die über die Länge des Stellstreifens eine konstante Breite aufweist. Die Abhebesensorfläche ist derart angeordnet, dass sie zusammen mit der Sensorfläche betätigt werden kann, insbesondere wird die Abhebesensorfläche in ihrer Ausdehnung quer zu dem Stellstreifen von den Querstreifen überdeckt. Durch die konstante Breite der Abhebesensorfläche, ist deren Sensorsignal bei Berührung des Stellstreifens unabhängig von der Berührposition längs des Stellstreifens und somit während eines Gleitens eines den Stellstreifen berührenden Fingers längs des Stellstreifens konstant. Auf diese Weise kann durch Vergleich von zeitlich aufeinander folgenden Signalwerten aufgrund deren Änderung oder durch Vergleich mit einem Referenzwert der Endzeitpunkt bzw. der Anfangszeitpunkt einer Berührung des Stellstreifens erkannt werden.

Gemäß einer bevorzugten Ausführungsform weist der Stellstreifen eine aktive Abschirmung auf. Die aktive Abschirmung ist durch eine Abschirmfläche gebildet, an der zeitgleich mit der Sensorfläche des Stellstreifens ein Taktsignal anliegt. Werden die Sensorfläche des Stellstreifens und die benachbart zur Sensorfläche liegende Abschirmfläche zeitgleich mit einem möglichst identischen bzw. dem gleichen Taktsignal versorgt, so bringt dies den Vorteil mit sich, dass es zwischen der Sensorfläche und der Abschirmfläche zu keinem Potenzialunterschied, damit zu keiner Ladungsverschiebung und somit zu keiner kapazitiven Beeinflussung der Sensorfläche kommt. Dies ist insbesondere bei Kapazitäten des mit der Sensorfläche gebildeten Kondensators in der Größenordnung von Piko-Farad wichtig, da in diesem Bereich selbst kleine Störkapazitäten von beispielsweise Leitungen, benachbarten sensorischen Flächen oder Metallgehäusen eine Messung der Kapazität des Kondensators beeinflussen. Durch eine Minimierung des Einflusses dieser Störkapazitäten auf die Sensorfläche mit Hilfe der aktiven Abschirmung ist es möglich, den Stellstreifen in der Nähe von metallischen Gehäuseteilen anzuordnen, selbst wenn diese geerdet sind. Darüber hinaus ist es nun nicht mehr nötig die Sensorfläche in unmittelbarer Nähe zur Auswerteelektronik des Stellstreifens zu platzieren, um Störkapazitäten zu minimieren, sondern die Sensorfläche kann zusammen mit der Abschirmfläche entfernt von der Auswerteelektronik angeordnet werden. Hierdurch wird es beispielsweise möglich, die Sensorfläche und die Verbindungsleitungen in Form einer preisgünstigen kupferkaschierten Polyesterfolie auszuführen, die einen Anschluss zu der Auswerteelektronik aufweist.

Je nach Anwendungsfall können die Abschirmfläche und die Sensorfläche unterschiedlich angeordnet sein. Gemäß einer bevorzugten Ausführungsform sind die Abschirmfläche und die Sensorfläche auf der gleichen Seite eines Trägermediums aufgebracht, wobei die Abschirmfläche die Sensorfläche rahmenförmig zumindest teilweise umgibt. Das Trägermedium kann dabei beispielsweise eine Leiterplatte, das Dielektrikum oder aber auch eine elastische Folie sein. Die Abschirmfläche und die Sensorfläche können auf diesem Trägermedium beispielsweise aufgedampft, aufgeklebt, aufgedruckt oder im Falle einer Leiterplatte je eine ihrer elektrisch leitfähigen Flächen sein. In einer alternativen Ausführungsform ist die Abschirmfläche auf der der Sensorfläche gegenüberliegenden Seite des Trägermediums zumindest im Bereich der Sensorfläche angeordnet. Auf diese Weise kann die Sensorfläche gegenüber rückwärtig angeordneter Leistungselektronik abgeschirmt werden. Des weiteren kann sich die aktive Abschirmung auch auf weitere sensorische Flächen des Stellstreifens erstrecken, wie beispielsweise die Endsensorfläche und/oder die Abhebesensorfläche, indem die Abschirmfläche beispielsweise die Endsensorfläche und/oder die Abhebesensorfläche ebenfalls zumindest teilweise umgibt. Es ist alternativ möglich für die verschiedenen sensorischen Flächen des Stellstreifens und/oder auch für benachbart angeordnete Sensortasten jeweils eigene aktive Abschirmungen vorzusehen. Bevorzugt ist allerdings eine gemeinsame Abschirmfläche für alle sensorischen Flächen des Stellstreifens bzw. für sensorische Flächen benachbart angeordnete Sensortasten, da sich auf diese Weise der Schaltungsaufwand verringert.

Die Querstreifen überdecken mit jeweils einem ersten Abschnitt die Sensorfläche und bilden damit einen Sensorbereich des Stellstreifens. Mit jeweils einem zweiten Abschnitt erstrecken sich die Querstreifen auf zumindest einer Seite quer zu dem Stellstreifen über die Sensorfläche hinaus und bilden zumindest mit ihrem zweiten Abschnitt den Betätigungsbereich des Stellstreifens. Auf diese Weise kann der Betätigungsbereich an einer anderen Position als der Sensorbereich angeordnet werden. Dadurch ist es möglich, den Betätigungsbereich beispielsweise mit einer Anzeige der Stellwerte zu verbinden. Vorzugsweise sind die Querstreifen aus einem transparenten elektrisch leitfähigen Material gebildet und überdecken mit ihrem Betätigungsbereich eine Anzeigeeinheit, wie beispielsweise eine Flüssigkristallanzeige oder ein Leuchtdiodendisplay, so dass innerhalb des Betätigungsbereichs die dem Stellstreifen zugeordneten einstellbaren bzw. eingestellten Stellwerte angezeigt bzw. symbolisiert werden können. Erfindungsgemäß sind die Querstreifen derart abgewinkelt, dass der Sensorbereich des Stellstreifens in einer ersten Ebene und der Betätigungsbereich des Stellstreifens in einer zu der ersten Ebene unter einem Winkel angeordneten zweiten Ebene liegt. Insbesondere stehen der Sensorbereich und der Betätigungsbereich senkrecht aufeinander. Dadurch ist der Platzbedarf des Stellstreifens quer zu seiner Längenausdehnung reduziert, wodurch der Stellstreifen auch bei geringem Einbauraum quer zur Längenausdehnung des Stellstreifens eingesetzt werden kann.

Gemäß einer weiteren bevorzugten Ausführungsform sind die Querstreifen und die Sensorfläche und/oder die Abhebesensorfläche in übereinanderliegenden Schichten auf einem gemeinsamen Trägermedium angeordnet oder bilden gemeinsam eine selbsttragende Baugruppe, wobei die jeweils aufeinanderfolgenden Schichten voneinander galvanisch isoliert sind. Auf diese Weise kann der Stellstreifen auch dann eingesetzt werden, wenn nur ein geringer Einbauraum zur Verfügung steht. Vorzugsweise ist die Baugruppe eine mehrlagige Leiterplatte, bei der die Schichten auf verschiedenen Lagen aufgebracht sind. Alternativ dazu können die verschiedenen Schichten mit den dazwischenliegenden Isolierschichten nacheinander beispielsweise durch Bedruckung oder Bedampfung direkt auf die Rückseite des Dielektrikums aufgebracht werden, wodurch sich der benötigte Einbauraum minimieren lässt.

Für eine sichere Funktionsfähigkeit des Stellstreifens ist eine bestimmte Mindestkapazität erforderlich, so dass je nach Material und Dicke des verwendeten Dielektrikums die Ausdehnung der Sensorfläche entsprechend angepasst sein muss. Da die Länge des Stellstreifens im wesentlichen durch den gewünschten Stellweg vorgegeben ist und die Breite des Stellstreifens beispielsweise nicht größer als eine Fingerkuppe sein sollte, kann die zur Verfügung stehende Fläche des Stellstreifens geringer als die benötigte Ausdehnung der Sensorfläche sein. Erfindungsgemäß sind daher in einer ersten Schicht erste Querstreifen angeordnet, in einer zweiten Schicht unterhalb der ersten Schicht ist die Sensorfläche angeordnet, und in einer dritten Schicht unterhalb der zweiten Schicht sind zweite Querstreifen angeordnet, wobei jeder der zweiten Querstreifen mit je einem unmittelbar darüber liegenden ersten Querstreifen galvanisch leitfähig verbunden ist. Diese Anordnung von ersten, zweiten Querstreifen und der dazwischen liegenden Sensorfläche entspricht bildlich gesprochen einer Faltung entlang einer Mittellinie der Sensorfläche längs des Stellstreifens, wobei die ungefaltete Sensorfläche spiegelsymmetrisch zu dieser Mittellinie ausgebildet ist. Die dabei Rücken an Rücken liegenden Schichten der Sensorflächen können nach dem bekannten Prinzip des Mehrfachkondensators durch eine einzige Schicht ersetzt werden. Es sind auch mehrere Faltungen dieser Art möglich, so dass Schichten mit Querstreifen und Schichten mit Sensorflächen jeweils abwechselnd übereinander liegen.

Damit der Stellstreifen auch bei feuchten Umgebungsbedingungen störungsfrei funktionieren kann, ist er, insbesondere seine elektrisch leitfähigen Flächen und/oder seine Auswerteschaltung, gegenüber Feuchtigkeit abgedichtet. Dazu kann die Auswerteschaltung beispielsweise auf eine bekannt Art und Weise eingeschweißt oder vergossen sein. Des weiteren kann der Stellstreifen zumindest zwei Gehäuseteile aufweisen, zwischen denen eine umlaufende Dichtung, wie z.B. eine geschäumten Silikonraupe oder ein Elastomerverbundteil, angeordnet ist, wobei insbesondere ein erstes Gehäuseteil durch das Dielektrikum gebildet sein kann. Vorzugsweise ist ein zweites Gehäuseteil eine Halterung für eine Leiterplatte des Stellstreifens, wobei diese Halterung bevorzugt an das erste Gehäuseteil durch beispielsweise Druckfedern angedrückt wird. In einer anderen Ausführungsform, in der der Stellstreifen eine flexible Leiterplatte oder eine kupferkaschierte Kunststofffolie aufweist, ist diese formschlüssig mit dem Dielektrikum verklebt. Auf diese Weise kann der Stellstreifen auch bei gekrümmten Bedienblenden verwendet werden.

Vorzugsweise ist ein Haushaltsgerät, wie beispielsweise eine Waschmaschine, ein Wäschetrockner, eine Geschirrspülmaschine, ein Gargerät, eine Dunstabzugshaube, ein Kältegerät, ein Klimagerät, ein Warmwasserbereiter oder ein Staubsauger, bzw. ein Eingabefeld für ein Haushaltsgerät mit zumindest einem erfindungsgemäßen Stellstreifen ausgestattet. Durch diesen Stellstreifen wird ein Schiebeschalter ohne mechanisch zu verschiebende Elemente gebildet, so dass das Haushaltsgerät mit einer das Eingabefeld umfassenden durchgängige Blende ausgestattet werden kann, wodurch das Haushaltsgerät gegenüber einem Eintritt von Verschmutzungen oder Feuchtigkeit geschützt ist. Die Blende entspricht dabei dem Dielektrikum und kann beispielsweise aus Glas, Glaskeramik, Keramik, Kunststoff, Holz oder Stein gefertigt sein. Zur Positionskennzeichnung des Stellstreifens kann an der Blendenoberseite oder bei durchsichtiger Blende an deren Unterseite eine Markierung, z.B. in Form eines Aufdrucks angebracht sein.

Insbesondere ist das Haushaltsgerät ein Glaskeramikkochfeld, bei dem in einem dem Benutzer zugewandten vorderen Bereich ein Eingabefeld mit einem oder mehreren der erfindungsgemäßen kapazitiven Stellstreifen angeordnet ist. Vorzugsweise ist jeder Kochstelle ein eigener Stellstreifen zugeordnet, über den die Leistungsstufe der zugehörigen Kochstelle eingestellt werden kann. Alternativ dazu ist ein einziger Stellstreifen vorgesehen, wobei die Zuordnung seiner Funktionalität zu den verschiedenen Kochstellen über zusätzliche Sensortasten erfolgt. Insbesondere ist dem Stellstreifen bzw. jedem der Stellstreifen ein Leuchtbalken zur Anzeige der eingestellten Leistungsstufe zugeordnet.

Es wird darauf hingewiesen, dass die Merkmale der Unteransprüche in beliebiger Weise miteinander kombinierbar sind.

Anhand von Zeichnungen wird die Erfindung nachstehend näher erläutert.
- Fig. 1: zeigt in einer schematischen Schnittansicht einen Ausschnitt einer Blende, beispielsweise eines Haushaltsgerätes, die ein Eingabefeld mit einem erfindungsgemäßen Stellstreifen aufweist,
- Fig. 2: zeigt schematisch eine Ausführungsform einer Sensorfläche des kapazitiven Stellstreifens bestehend aus zwei dreieckförmigen Teilflächen,
- Fig. 3a bis 3d: zeigen schematisch Ausführungsformen des erfindungsgemäßen Stellstreifens, wobei dessen Sensorflächen durch Querstreifen überdeckt sind,
- Fig. 4: zeigt schematisch eine weitere Ausführungsform des erfindungsgemäßen Stellstreifens mit einer Abhebesensorfläche,
- Fig. 5: zeigt schematisch eine weitere Ausführungsform des erfindungsgemäßen Stellstreifens mit einem Testquerstreifen,
- Fig. 6a, 6b: zeigen schematisch weitere Ausführungsformen des erfindungsgemäßen Stellstreifens mit Endsensorflächen,
- Fig. 7a, 7b: zeigen schematisch in einer weiteren Ausführungsform des erfindungsgemäßen Stellstreifens dessen sensorische Flächen mit einer aktiven Abschirmung,
- Fig. 8: zeigt einen Schichtaufbau des erfindungsgemäßen Stellstreifens,
- Fig. 9a, 9b: zeigen Prinzipschaltbilder des Stellstreifens gemäß Figur 8.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungsschalters gemäß der Erfindung in sämtlichen Zeichnungsfiguren durch gleiche Bezugszeichen bezeichnet sind. Werden in einer Zeichnung mehrere Elemente bzw. Einzelteile gleicher Art verwendet, auf die unterschiedlich Bezug genommen wird, so wird für die führende(n) Stelle(n) der entsprechenden Bezugszeichen jeweils die gleiche(n) Ziffer(n) gewählt. Die folgenden Stellen der entsprechenden Bezugszeichen dienen dazu, die Elemente bzw. Einzelteile gleicher Art zu unterscheiden.

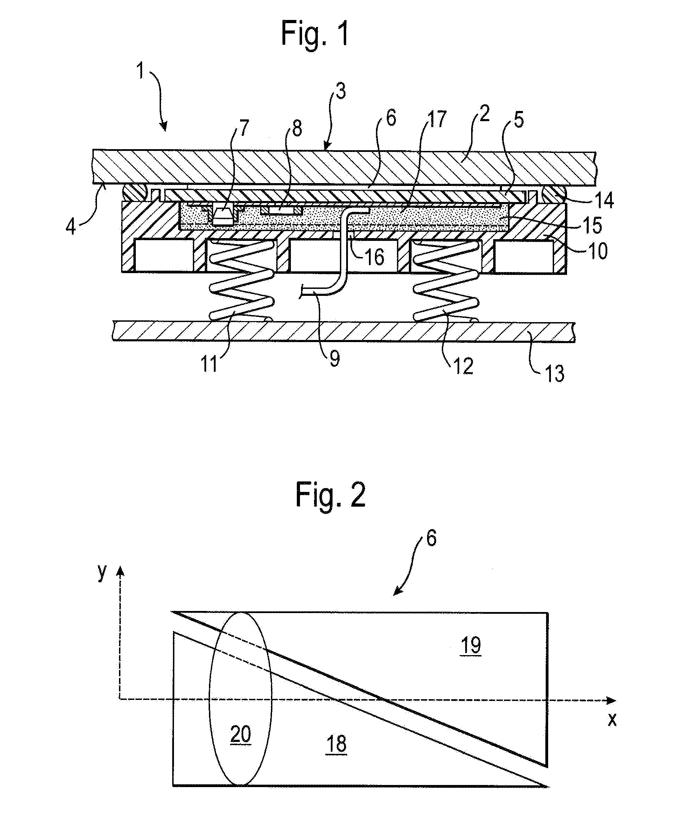

In Figur 1 ist in einer schematischen Schnittansicht ein Ausschnitt eines Eingabefeldes 1, beispielsweise eines Haushaltgerätes, mit einer Blende 2 gezeigt, das einen erfindungsgemäßen kapazitiven Stellstreifen 3 aufweist. Die Blende 2 ist als elektrisch isolierende Abdeckplatte aus einem Dielektrikum, wie beispielsweise Glas, Glaskeramik, Keramik, Kunststoff, Holz oder Stein ausgebildet. An der Rückseite 4 der Blende 2 ist eine Leiterplatte 5 mit einer der Rückseite 4 der Blende 2 zugewandten elektrisch leitfähigen Sensorfläche 6 angeordnet. Die Leiterplatte 5 kann eine Kunststoffplatte sein, die auf wenigstens einer ihrer Plattenseiten die erwähnte Sensorfläche 6 und gegebenenfalls Leiterbahnen aufweist, über die die Sensorfläche 6 mit einem elektrischen Schaltkreis (nicht gezeigt) des kapazitiven Stellstreifens 3 elektrisch leitend verbunden ist. Der elektrische Schaltkreis des kapazitiven Stellstreifens 3 kann auf der Vorder- oder Rückseite der Leiterplatte 5 oder auf einer separaten Platine angeordnet sein. In der in Figur 1 gezeigten Ausführungsform ist die Leiterplatte 5 an der der Sensorfläche 6 abgewandten Seite mit Bauelementen 7, 8 des dem Stellstreifen 3 zugehörigen elektrischen Schaltkreises bestückt. Des weiteren weist die Leiterplatte 5 eine elektrische Verbindung 9 zu einer Geräteelektronik (nicht gezeigt) auf, die durch Betätigung des Stellstreifens 3 beeinflusst werden kann.

Die Leiterplatte 5 ist in einer Halterung 10 aufgenommen, die vorzugsweise aus Kunststoff besteht, wie beispielsweise Polyamid 6 (PA6) oder Polybutylenterephthalat (PBT), und die insbesondere eine Gehäuseschale für die Leiterplatte 5 mit ihren Bauelementen 7, 8 bildet. Je nach Wahl des Kunststoffes kann die Halterung 10 Dauertemperaturbelastungen und/oder kurzzeitige Temperaturbelastungen schadlos überstehen, wie beispielsweise Dauertemperaturbelastungen von 125°C und kurzzeitige Temperaturbelastungen von 150°C bei Glaskeramikkochfeldern. An der Halterung 10 greifen Druckfedern 11, 12 an, die ihr Widerlager an einem Elektronikgehäuseboden 13 oder an einer weiteren Elektronikplatine der Eingabe-/Ausgabeelektronik (nicht gezeigt) haben. Durch die unter Druckspannung stehenden Druckfedern 11, 12 wird die in der Halterung 10 angeordnete Leiterplatte 5 mit ihrer Sensorfläche 6 an die Rückseite 4 der Blende 2 angedrückt, so dass die Sensorfläche 6 gleichmäßig an der Rückseite 4 der Blende 2 anliegt. Die Druckfedern 11, 12 können in verschiedener Form und unterschiedlichem Material ausgebildet sein, beispielsweise als metallische Schraubendruck- oder Blattfedern oder als zylinder-, kegel- oder quaderförmiger Körper aus elastischem Kunststoffmaterial. Ist zumindest eine der Druckfedern 11, 12 aus elektrisch leitfähigen Material ausgebildet, so kann diese als elektrische Verbindung 9 zwischen der Leiterplatte 5 und der Geräteelektronik genutzt werden.

Um die Sensorfläche 6 bzw. die Leiterplatte 5 gegenüber Umgebungsfeuchtigkeit abzudichten, ist zwischen der Halterung 10 und der Unterseite 4 der Blende 2 eine umlaufende Dichtung 14 angeordnet, die die Sensorfläche 6 bzw. die Leiterplatte 5 rahmenförmig umgibt. Diese Dichtung 14 ist vorzugsweise verliersicher mit der Halterung 10 verbunden. Anstatt an der Halterung 10 kann die Dichtung 14 auch direkt an der Leiterplatte 5 angeordnet sein, wenn sie entsprechend dünn ausgeführt ist, so dass die Sensorfläche 6 an der Rückseite 4 der Blende 2 anliegen kann. Beispielsweise ist die Dichtung 14 eine frei aufgetragene, geschäumte Silikonraupe oder ein Elastomerverbundteil. Die Dichtung 14 wird aufgrund der unter Druckspannung stehenden Druckfedern an die Rückseite 4 der Blende gepresst, wobei durch die Elastizität der Dichtung 14 Unebenheiten der Rückseite 4 der Blende 2 ausgeglichen werden. Darüber hinaus bzw. alternativ zu der Dichtung 14 kann die der Sensorfläche 6 abgewandte Seite der Leiterplatte 5 mit den zu dem elektrischen Schaltkreis des kapazitiven Stellstreifens 3 gehörenden Bauteilen 7, 8 vergossen sein, um eine Abdichtung gegen Umgebungsfeuchtigkeit zu erzielen. In der Ausführungsform gemäß Figur 1 ist in der Halterung 10 ein Durchbruch 16 vorgesehen, durch den die elektrische Verbindung 9 geführt ist. Durch diesen Durchbruch 16 kann bei dem Fertigungsprozess des kapazitiven Stellstreifens 3 in einen zwischen der Halterung 10 und der Leiterplatte 5 befindlichen Hohlraum 17 eine Vergussmasse 15 eingefüllt werden, so dass zum einen die der Sensorfläche 6 abgewandte Seite der Leiterplatte 5 mit den zu dem elektrischen Schaltkreis des kapazitiven Stellstreifens 3 gehörenden Bauteilen 7, 8 vergossen und zum anderen die Leiterplatte 5 durch die Vergussmasse 15 in der Halterung 10 fixiert ist.

Die elektrisch leitende Schicht der Sensorfläche 6 kann in verschiedenen Formen ausgebildet sein, je nach geometrischem Verlauf des Stellstreifens beispielsweise gebogen oder geradlinig. Des weiteren kann sich die Sensorfläche 6 aus einer unterschiedlichen Anzahl von Teilflächen zusammensetzen. In Figur 2 ist schematisch eine Ausführungsform einer Sensorfläche 6 gezeigt, die durch zwei elektrisch leitfähige Teilflächen 18, 19 gebildet ist, die voneinander galvanisch isoliert sind. Die Teilflächen 18 und 19 sind in Form rechtwinkliger Dreiecke ausgebildet und benachbart derart angeordnet, dass sie sich mit ihrer jeweiligen Hypotenuse gegenüberliegen. Bei Berührung der Blende 2 im Bereich des Stellstreifens 3 wird nun, beispielsweise durch den Finger eines Benutzers, entsprechend der Berührposition 20 ein Teil der Sensorfläche 6 überdeckt. Je nachdem an welcher Position relativ zu der lateralen Ausdehnung der Teilflächen 18, 19 in x-Richtung die Berührung durch den Benutzer erfolgt, ist aufgrund der Dreiecksform der Teilflächen 18, 19 die Kapazität der mit den Teilflächen 18, 19 gebildeten Kondensatoren unterschiedlich. Somit kann anhand der den Teilflächen 18, 19 zugehörigen Ausgangssignale die Position der Betätigung bestimmt und damit ein dieser Position entsprechender bzw. zugeordneter Schaltzustand ausgelöst werden, d.h. die Teilflächen 18, 19 bilden zusammen einen Positionssensor. Bei einer Änderung bzw. Verschiebung der Berührposition 20, indem beispielsweise der Benutzer seinen Finger auf der Blende 2 verschiebt, wird diese Änderung ebenfalls detektiert und gegebenenfalls ein der neuen Position entsprechender Schaltzustand ausgelöst. Auf diese Weise bildet der Stellstreifen 3 einen Schiebeschalter ohne mechanisch zu verschiebende Elemente, durch den beispielsweise eine Kochstufe bei einer Kochstelle eines Kochfelds, eine Temperatur bei einem Klimagerät oder bei einem Kältegerät eingestellt werden kann.

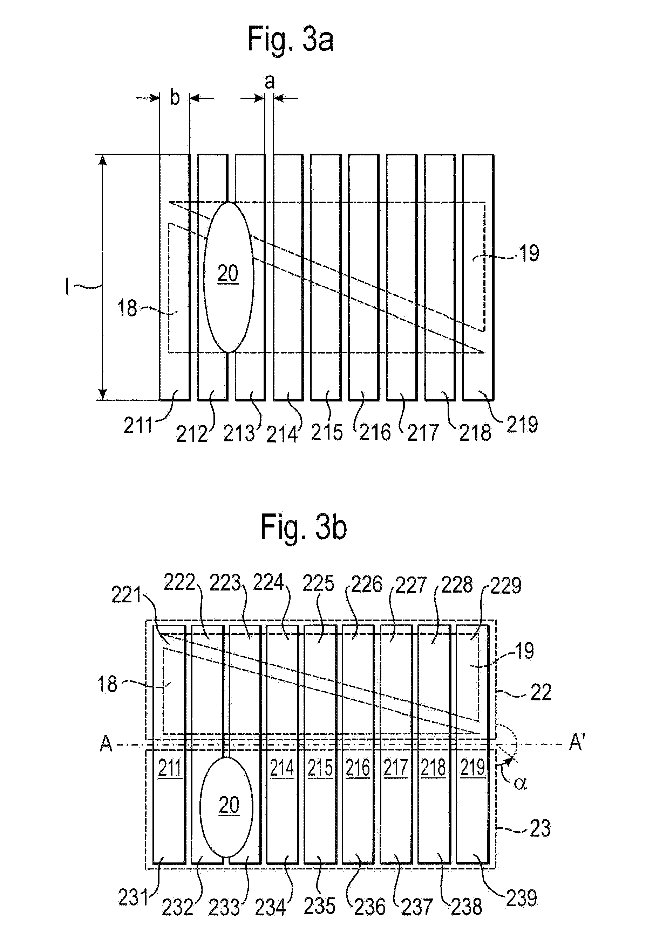

In den in Figur 3a und 3b gezeigten erfindungsgemäßen Ausführungsformen sind längs des Stellstreifens 3 galvanisch isoliert zu der Sensorfläche 6 bzw. deren Teilflächen 18, 19 und galvanisch isoliert zueinander eine Vielzahl von elektrisch leitfähigen Querstreifen 211 bis 219 nebeneinander angeordnet. Diese überdecken die Sensorfläche 6 in ihrer Ausdehnung quer zu dem Stellstreifen 3 in y-Richtung und dienen dazu eine Ungenauigkeit der Berührposition 20 quer zu dem Stellstreifen 3 in y-Richtung auszugleichen. Die einzelnen Querstreifen 211 bis 219 haben jeweils gleiche Breite b und Länge I und weisen zwischen zwei benachbarten Querstreifen 21i und 21 i+1 (i= 1,...,9) jeweils einen gleichen Abstand a auf. In der in Figur 3b gezeigten Ausführungsform überdecken die Querstreifen 21 i (i=1,...,9) mit jeweils einem ersten Abschnitt 22i (i=1,...,9) die Sensorfläche 6 bzw. die beiden Teilflächen 18 und 19 und bilden damit einen Sensorbereich 22. Mit jeweils einem zweiten Abschnitt 23i (i=1,...,9) erstrecken sich die Querstreifen 21i (i=1,...,9) auf einer Seite quer zu dem Stellstreifen 3 in y-Richtung über die Sensorfläche 6 bzw. die beiden Teilflächen 18, 19 hinaus und bilden zumindest mit diesem zweiten Abschnitt 23i (i=1,...,9) einen Betätigungsbereich 23 des Stellstreifens 3. Der Betätigungsbereich 23 kann sich in y-Richtung über die gesamte Länge I der Querstreifen 21 i (i=1,...,9) erstrecken, so dass er den Sensorbereich 22 mit umfasst bzw. der Sensorbereich 22 kann ein Teilbereich des Betätigungsbereichs 23 sein. Es ist aber auch möglich, den Betätigungsbereich 23 an einer anderen Stelle als den Sensorbereich 22 anzuordnen. Beispielsweise können die Querstreifen 21i (i=1,...,9) entlang der Linie AA' in Figur 3b abgewinkelt sein. Vorzugsweise liegt der Betätigungsbereich 23 des Stellstreifens 3 in einer ersten Ebene, die insbesondere parallel zu der Blende 2 angeordnet ist, und der Sensorbereich 22 liegt in einer zu der ersten Ebene unter einem Winkel α angeordneten zweiten Ebene, wobei der Winkel α insbesondere größer ist als Null Grad und vorzugsweise 90 Grad beträgt.

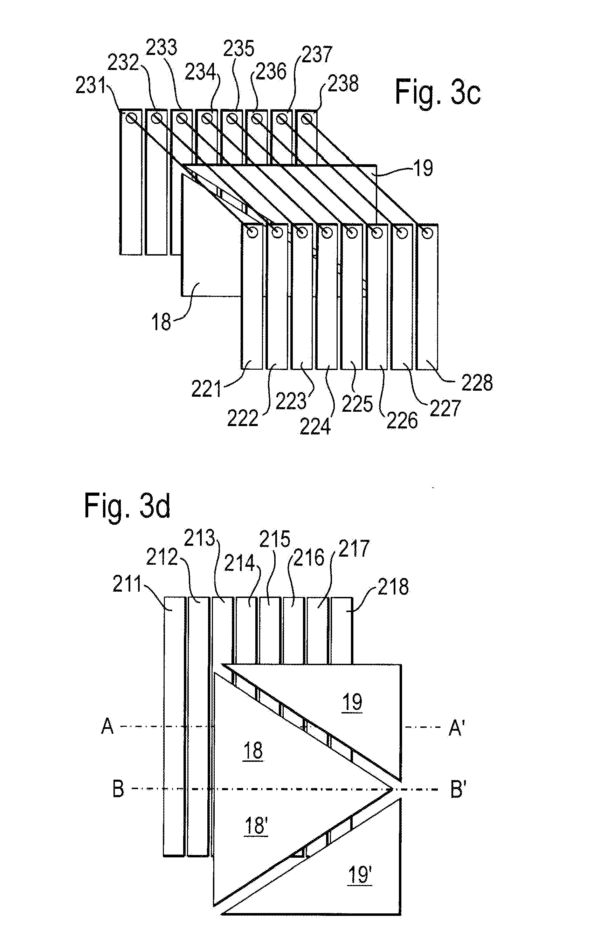

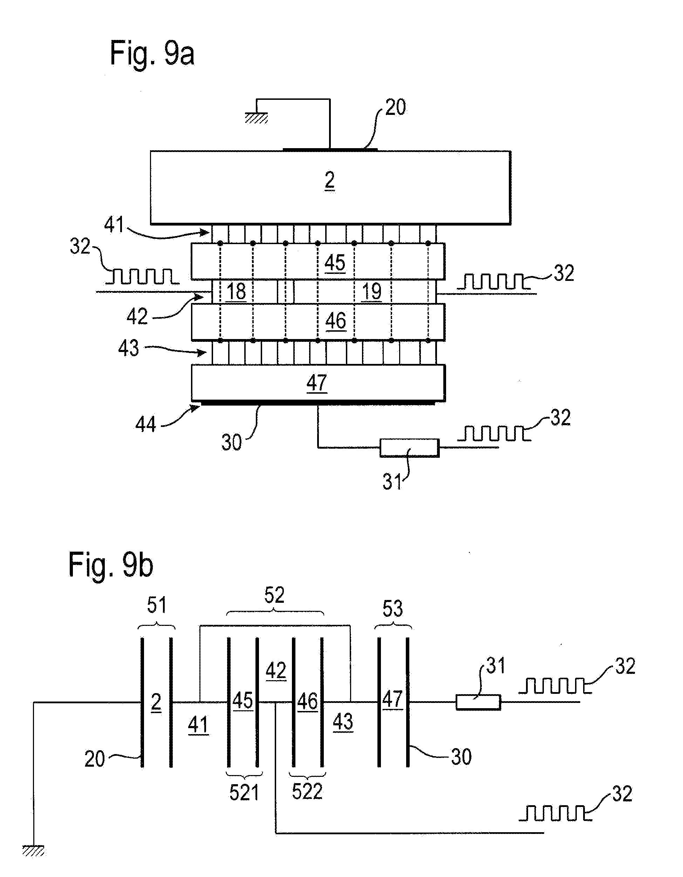

In Figur 3c ist eine besonders vorteilhafte Ausführungsform gezeigt, bei der der Winkel α zwischen den beiden Ebenen der ersten Abschnitte 22i und der zweiten Abschnitte 23i der Querstreifen 21 i (i=1,...,8) 180 Grad beträgt, so dass der erste Abschnitt 22i und der zweite Abschnitt 23i jeweils parallel übereinander angeordnet sind. In diesem Fall entspricht der Betätigungsbereich 23 dem Sensorbereich 22 des Stellstreifens 3. Zwischen den ersten Abschnitten 22i und den zweiten Abschnitten 23i der Querstreifen 21i (i=1,...,8) ist die Sensorfläche 6 bzw. sind deren Teilflächen 18 und 19 angeordnet. Dies entspricht anschaulich, wie in Figur 3d gezeigt, einer Faltung entlang einer Mittellinie BB' der Sensorfläche 6 längs des Stellstreifens in x-Richtung, wobei die ungefaltete Sensorfläche 6 mit ihren Teilflächen 18, 18' und 19, 19' spiegelsymmetrisch zu dieser Mittellinie BB' ausgebildet ist. Die bei der Faltung Rücken an Rücken liegenden Teilflächen 18 und 18' bzw. 19 und 19' sind in Figur 3c durch eine einzige Schicht mit den Teilfläche 18 und 19 ersetzt worden. Die Sensorfläche 6 bzw. deren Teilflächen 18 und 19 ist bzw. sind zu den ersten Abschnitten 22i und den zweiten Abschnitten 23i der Querstreifen 21i (i=1,...,8) jeweils galvanisch isoliert, beispielsweise durch eine dielektrische Zwischenschicht (vgl. Figur 9a). Bei jedem der Querstreifen 21i (i=1,...,8) ist der erste Abschnitt 22i mit dem zweiten Abschnitt 23i galvanisch leitfähig verbunden. Auf diese Weise kann bei gleichbleibender Sensorkapazität des Stellstreifens 3 bzw. der Querstreifen 21i (i=1,...,8) und der Teilflächen 18, 19 die Abmessung des Stellstreifens 3 in y-Richtung halbiert werden. Eine weitere Reduzierung dieser Abmessung kann durch weitere Faltungen erzielt werden.

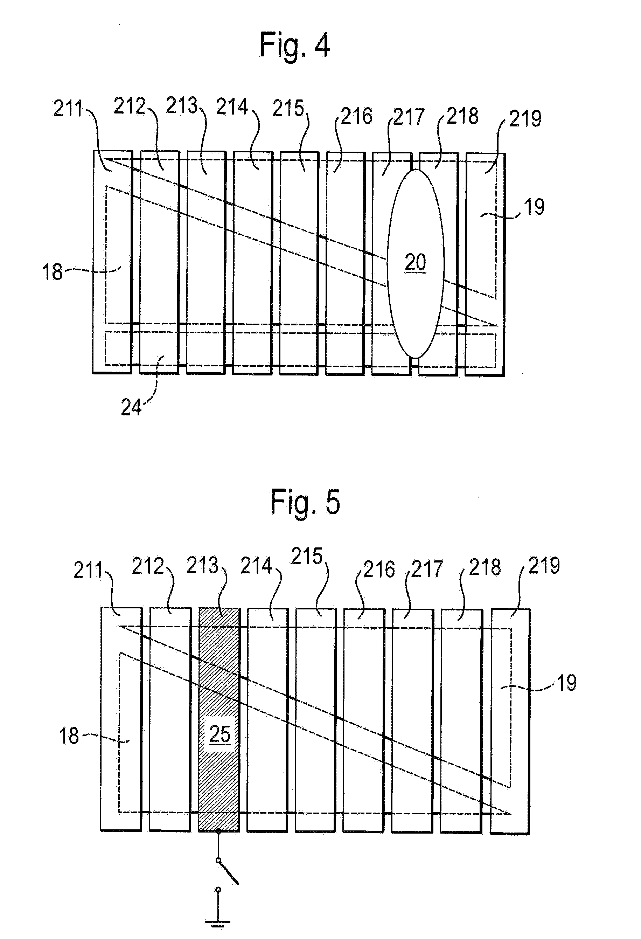

In Figur 4 ist in einer weiteren Ausführungsform des erfindungsgemäßen Stellstreifens 3 entlang des Stellstreifens in x-Richtung parallel zu der durch die Teilflächen 18, 19 gebildeten rechteckigen Sensorfläche 6 eine Abhebesensorfläche 24 angeordnet. Die Abhebesensorfläche 24 weist im Gegensatz zu den dreieckigen Teilflächen 18, 19 über die gesamte Länge des Stellstreifens 3 in x-Richtung eine konstante Breite auf und ist gemäß Figur 4 somit rechteckig ausgebildet. Durch die konstante Breite der Abhebesensorfläche 24, ist ein bei Berührung des Stellstreifens 3 erzeugtes Sensorsignal der Abhebesensorfläche 24 unabhängig von der Berührposition 20 und somit während eines Gleitens des Fingers entlang des Stellstreifens 3 in x-Richtung konstant. Ein Anfangszeitpunkt bzw. ein Endzeitpunkt der Berührung des Stellstreifens 3 kann durch Vergleich von zeitlich aufeinander folgender Signalwerten der Abhebesensorfläche 24 oder durch Vergleich der Signalwerte der Abhebesensorfläche 24 mit einem Referenzwert bestimmt werden. Vorzugsweise wird die Abhebesensorfläche 24 in ihrer Ausdehnung in y-Richtung also quer zu dem Stellstreifen 3 von den Querstreifen 21i (i=1,...,9) überdeckt, so dass ihre Signalwerte unabhängig von Ungenauigkeiten der Berührposition 20 in y-Richtung sind. Die Abhebesensorfläche 24 kann wie in Figur 4 gezeigt auf derselben Seite der Leiterplatte 5 wie die Sensorfläche 6 bzw. die Teilflächen 18, 19 der Sensorfläche 6 oder in einer alternativen Ausführungsform der der Sensorfläche 6 abgewandten Seite der Leiterplatte 5 angeordnet sein.

Zur Funktionsprüfung des Stellstreifens 3 ist in einer weiteren Ausführungsform des erfindungsgemäßen Stellstreifens 3 gemäß Figur 5 der Querstreifen 213 als Testquerstreifen 25 ausgebildet, der zum Anlegen von Massepotenzial mit Masse verbindbar ist. Unter Masse wird hier ein festes Potenzial, wie beispielsweise Erdpotenzial oder ein Bezugspotenzial einer Auswerteschaltung des Stellstreifens 3 verstanden. Durch Anlegen von Massepotential an den Testquerstreifen 25 kann eine Betätigung des Stellstreifens 3 an der Position des Testquerstreifens 25 simuliert werden. Auf diese Weise kann überprüft werden, ob ein ausreichender Signalhub des Ausgangssignals bei Betätigung des Stellstreifens 3 vorliegt, oder ob eventuell aufgrund von Verunreinigungen oder Benetzung der Blende 2 oder aufgrund von Alterungsprozessen des Stellstreifens 3 eine Fehlfunktion vorliegt. Eventuell kann der Signalhub des Ausgangssignals durch Änderung der Höhe eines Eingangssignals des Stellstreifens 3 dynamisch angepasst werden, d.h. der Stellstreifen 3 kann automatisch kalibriert werden. Wenn aufgrund beispielsweise einer verschmutzten Blende 2 eine sichere Funktion des Stellstreifens 3 nicht mehr gewährleistet ist, kann das zugehörige Gerät automatisch abgeschaltet oder zumindest über eine eventuell vorhandene Anzeigevorrichtung die Fehlfunktion des Stellstreifens signalisiert werden.

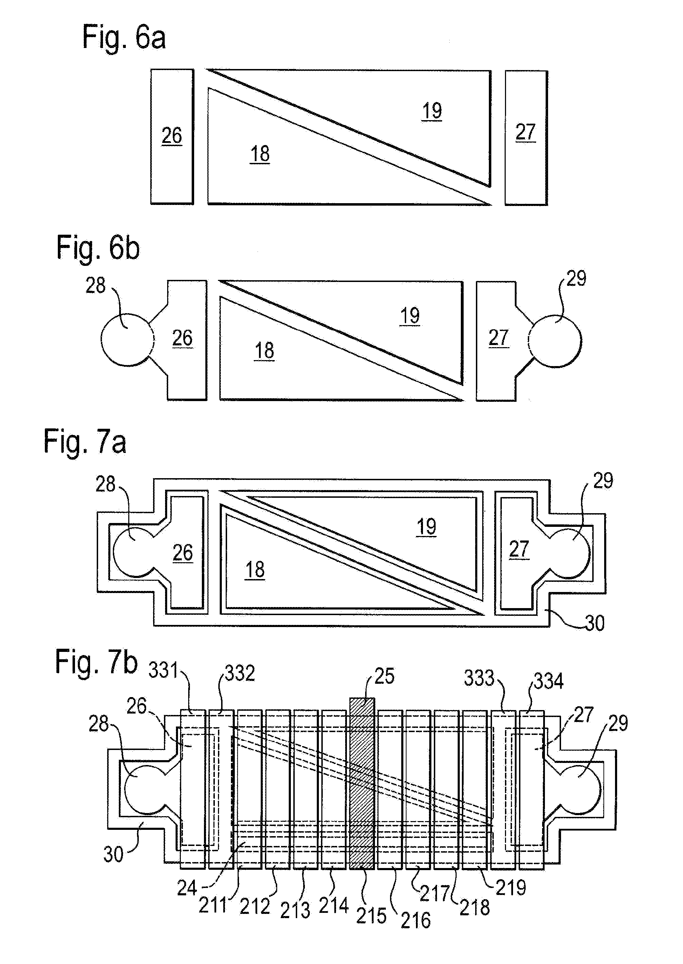

In den Figuren 6a und 6b sind weitere Ausführungsformen des erfindungsgemäßen Stellstreifens 3 mit Endsensorflächen 26, 27 gezeigt. An jedem Ende des Stellstreifens 3 schließt sich in x-Richtung an die Sensorfläche 6 bzw. deren Teilflächen 18, 19 galvanisch isoliert zu diesen je eine Endsensorfläche 26, 27 an. Die Endsensorflächen 26, 27 sind jeweils als rechteckige, elektrisch leitfähige Flächen ausgebildet. Sie können aber auch andere Formen aufweisen, wie beispielsweise dreieckig, rund oder oval. Beim Gleiten des Fingers entlang des Stellstreifens 3 in x-Richtung bis zur Berührung der Endpositionen des Stellstreifens 3 wird somit neben den Ausgangssignal der Sensorfläche 6 bzw. den Teilflächen 18, 19 ein Ausgangssignal der entsprechenden Endsensorfläche 26 oder 27 erzeugt. Anhand des Ausgangssignals der Endsensorfläche 26 bzw. 27 kann die Berührung der entsprechenden Endposition des Stellstreifens 3 eindeutig erkannt werden. In der Ausführungsform gemäß Figur 6b umfasst die Form jeder der Endsensorflächen 26 bzw. 27 jeweils eine elektrisch leitfähige Fläche 28 bzw. 29 einer benachbart angeordneten Sensortaste. Eine Auswertung, ob eine Berührung in dem gemeinsamen Bereich der Endsensorfläche 26 bzw. 27 und der Sensorfläche 28 bzw. 29 der benachbart angeordneten Sensortaste eine Einstellung eines Stellwertes des Stellstreifens 3 oder eine Schaltung der Sensortaste bezweckt, erfolgt per Softwareprogramm, beispielsweise in einem Mikroprozessor einer gemeinsamen Auswerteschaltung des Stellstreifens 3 und der Sensortaste. Insbesondere sind wie in Figur 7b gezeigt an den Positionen der Endsensorflächen 26, 27 zusätzliche Querstreifen 331 bis 334 angeordnet, so dass auch für die Endsensorflächen 26, 27 Ungenauigkeiten der Berührposition 20 quer zu dem Stellstreifen 3 ausgeglichen werden können.

Der erfindungsgemäße kapazitive Stellstreifen 3 kann des weiteren mit einer aktiven Abschirmung ausgestattet sein. Dazu sind, wie beispielsweise in Figur 7a und 7b gezeigt, sensorischen Flächen des kapazitiven Stellstreifens 3, wie die Teilflächen 18,19, die Endsensorflächen 28, 29 und/oder die Abhebesensorfläche 24 von einer elektrisch leitfähigen Abschirmfläche 30 rahmenförmig umgeben, wobei die Form dieses Rahmens der Außenkontur der sensorischen Flächen angepasst ist. Es kann jeder oder mehreren der sensorischen Flächen eine eigene Abschirmfläche oder wie in Figur 7a und 7b gezeigt allen sensorischen Flächen eine einzige, zusammenhängende Abschirmfläche 30 zugeordnet sein. Des weiteren kann die Abschirmfläche 30 auf der gleichen Seite der Leiterplatte 5 wie die Sensorfläche 6 und benachbart zu dieser oder in einer alternativen Ausführungsform auf der der Sensorfläche 6 abgewandten Seite der Leiterplatte 5 angeordnet sein. Auch in letzterem Fall kann jeder der sensorischen Flächen des kapazitiven Stellstreifens 3 eine eigene Abschirmfläche oder allen gemeinsam eine einzige Abschirmfläche zugeordnet sein, die sich über die gesamte Leiterplatte 5 erstreckt oder die zumindest den Bereich der Leiterplatte 5 abdeckt, der den sensorischen Flächen gegenüberliegt.

Die aktive Abschirmung wird dadurch gebildet, dass an der Abschirmfläche 30, vorzugsweise über einen niederohmigen Widerstand 31 (siehe Figuren 9a, 9b), jeweils zeitgleich mit derjenigen bzw. denjenigen der von ihr umgebenen bzw. abgeschirmten sensorischen Flächen ein, insbesondere periodisches Taktsignal 32 anliegt, die im Hinblick auf eine eventuelle Betätigung ausgewertet wird bzw. werden. Durch geeignete Wahl des niederohmigen Widerstands 31 kann die Signalform des Taktsignals 32 an der Abschirmfläche 30 an die Signalform des Taktsignals 32 an den sensorischen Flächen des Stellstreifens 3, wie z.B. die Sensorfläche 6, die Teilflächen 18, 19, die Endsensorflächen 28, 29 und/oder die Abhebesensorfläche 24 angeglichen werden, so dass keine Verschiebung von Ladungsträgern zwischen der Abschirmfläche 30 und jeweils der im Hinblick auf eine eventuelle Betätigung auszuwertenden sensorischen Fläche auftritt und somit die Abschirmung dieser sensorischen Fläche durch die Abschirmfläche 30 gegenüber Störkapazitäten gewährleistet ist. Die verschiedenen sensorischen Flächen des Stellstreifens 3 werden bevorzugt jeweils für eine vorgegebene Zeitdauer, d.h. für eine vorgegebene Anzahl an Taktperioden in einem zeitlichen Multiplexverfahren mit dem Taktsignal 32 beaufschlagt, so dass sie nacheinander dahingehend überprüft werden, ob bzw. an welcher Berührposition 20 eine Betätigung des Stellstreifens 3 durch einen Benutzer vorliegt. Das Taktsignal 32 ist vorzugsweise ein rechteckförmiges Spannungssignal, welches beispielsweise von einem Mikroprozessor (nicht gezeigt) regelmäßig zwischen Massepotenzial, d.h. LOW-Pegel, und Betriebsspannung des Schaltkreises des Stellstreifens 3, d.h. HIGH-Pegel, umgeschaltet wird, wobei das Massepotenzial von dem Erdpotenzial des Benutzers verschieden sein kann. Die Taktfrequenz des Taktsignals 32 liegt bevorzugt im Bereich zwischen 10 und 100 Kilohertz.

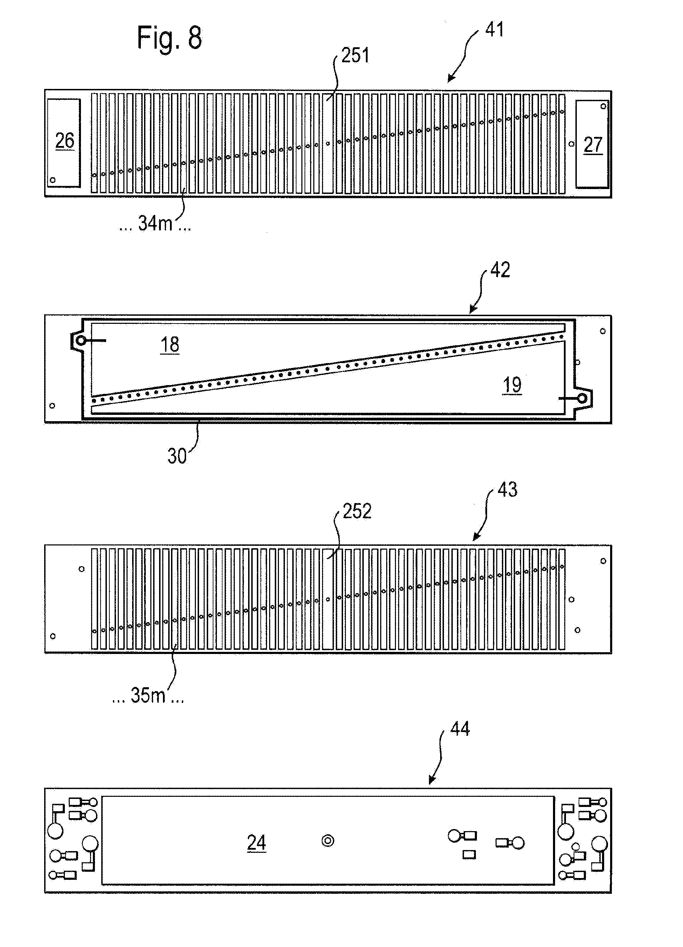

In Figur 8 ist ein Schichtaufbau des erfindungsgemäßen Stellstreifens 3 gezeigt. In einer ersten Schicht 41 sind erste Querstreifen 34m (m=1,..., 52) angeordnet, die entsprechend den zweiten Abschnitten 23i der Querstreifen 21i gemäß Figur 3c den Berührbereich 23 des Stellstreifens 3 bilden. Mittig zu der ersten Querstreifen 34m ist ein erster Teil 251 des Testquerstreifens 25 angeordnet, der in dieser Ausführungsform doppelt so breit wie einer der ersten Querstreifen 34m ausgebildet ist. Benachbart zu den ersten Querstreifen 34m weist die ersten Schicht 41 an den Enden des Stellstreifens 3 Endsensorflächen 26, 27 auf. In einer zweiten Schicht 42, die unterhalb der ersten Schicht 41 mit einer dazwischenliegenden ersten Isolierschicht 45 (vgl. Figur 9a) angeordnet ist, sind die dreieckigen Teilflächen 18 und 19 der Sensorfläche von der Abschirmfläche 30 umrahmt. Eine dritten Schicht 43, die unterhalb der zweiten Schicht 42 mit einer dazwischenliegenden zweiten Isolierschicht 46 angeordnet ist, weist zweite Querstreifen 35m (m=1,..., 52) auf, die entsprechend den ersten Abschnitten 22i der Querstreifen 21 i gemäß Figur 3c den Sensorbereich 22 des Stellstreifens 3 bilden. Mittig zu den zweiten Querstreifen 35m ist ein zweiter Teil 252 des Testquerstreifens 25 angeordnet. Jeder der zweiten Querstreifen 35m der dritten Schicht 43 ist mit dem unmittelbar über ihm liegenden ersten Querstreifen 34m der ersten Schicht 41 durch die zweite Schicht 42, die erste Isolierschicht 45 und die zweite Isolierschicht 46 hindurch galvanisch leitfähig verbunden. Analog dazu ist auch der erste Teil 251 mit dem zweiten Teil 252 des Testquerstreifens 25 galvanisch leitfähig verbunden. Die Verbindungen zwischen ersten Querstreifen 34m und zweiten Querstreifen 35m, sowie zwischen erstem Teil 251 und zweitem Teil 252 des Testquerstreifens 25 sind zwischen den Hypotenusen der Teilflächen 18 und 19 galvanisch isoliert zu den Teilflächen 18 und 19 angeordnet. In einer vierten Schicht 44, die unterhalb der dritten Schicht 43 mit einer dazwischenliegenden dritten Isolierschicht 47 angeordnet ist, ist die Abhebesensorfläche 24 aufgebracht. Die Abhebesensorfläche 24 kann auch als aktive Abschirmung genutzt werden, indem sie zeitgleich zu den Teilflächen 18, 19 bzw. den Endensorflächen 26, 27 mit dem Taktsignal 32 beaufschlagt wird. Des weiteren weist die vierte Schicht 44 Kontaktstellen für die Endsensorflächen 26, 27, die Teilflächen 18, 19, den Testquerstreifen 25 und die Abschirmfläche 30 auf. Die vier Schichten 41, 42, 43, 44 können in verschiedenen Lagen einer mehrlagigen Leiterplatte 5 angeordnet sein, wobei die drei Isolierschichten 45, 46, 47 durch das dieelektrische Material der verschiedenen Lagen der Leiterplatte 5 gebildet werden. Auf diese Weise bildet die mehrlagige Leiterplatte 5 eine selbsttragende Baugruppe. Es ist aber auch möglich, die vier Schichten 41, 42, 43, 44 mit den dazwischen angeordneten Isolierschichten 45, 46, 47 direkt auf die Rückseite 4 der Blende 2 aufzubringen, indem sie beispielsweise aufgedampft oder aufgedruckt werden.

In Figur 9a und 9b sind Prinzipschaltbilder des kapazitiven Stellstreifens 3 gezeigt. Der Finger eines Benutzers führt ein vom Potenzial der Sensorfläche 6 bzw. deren Teilflächen 18, 19 verschiedenes Potenzial, insbesondere Erdpotenzial, so dass an der Berührposition 20 der Blende 2 dieses Potenzial anliegt. Der Finger des Benutzers an der Berührposition 20 bildet mit den ersten Querstreifen 34m der ersten Schicht 41 einen ersten Kondensator 51. Die ersten Querstreifen 34m sind mit den zweiten Querstreifen 35m der dritten Schicht 43 galvanisch leitfähig verbunden, so dass Ladungsträgerverschiebungen von den ersten Querstreifen 34m auf die zweiten Querstreifen 35m übertragen werden. Die ersten Querstreifen 34m bilden somit mit der Sensorfläche 6 bzw. deren Teilflächen 18, 19 der zweiten Schicht 42 einen ersten Teil 521 eines zweiten Kondensators 52. Die zweiten Querstreifen 35m bilden mit der Sensorfläche 6 bzw. deren Teilflächen 18, 19 einen zweiten Teil 522 des zweiten Kondensators 52. Die Abschirmfläche 30 oder die Abhebesensorfläche 24 der vierten Schicht 44 bilden mit den zweiten Querstreifen 35m der dritten Schicht 43 einen dritten Kondensator 53. Berührt der Benutzer den Stellstreifen 3 an der Oberfläche der Blende 2, so ruft dies eine Kapazitätsänderung der ersten Kondensators 51 und diese wiederum eine Kapazitätsänderung des zweiten Kondensators 52 hervor. Die Kapazitätsänderung des zweiten Kondensators 52 teilt sich je nach Berührposition 20 unterschiedlich auf die beiden Teilflächen 18 und 19 der Sensorfläche 6 auf. Die beiden Teilflächen 18, 19 sind elektrisch leitfähig mit dem Schaltkreis des Stellstreifens 3 verbunden und werden durch diesen mit einem Taktsignal 32 beaufschlagt. Durch dieses Taktsignal 32 werden die Aufteilung der Kapazitätsänderung auf die beiden Teilflächen 18, 19 detektiert und dadurch die Berührposition 20 und ein der Berührposition zugeordneter Stellwert des Stellstreifens bestimmt. Durch eine Beaufschlagung der Abschirmfläche 30 mit dem Taktsignal 32 zeitgleich zu der Sensorfläche 6, werden Störpotenziale der Umgebung aktiv abgeschirmt.

### Bezugszeichenliste

- 1: Eingabefeld
- 2: Blende
- 3: kapazitiver Stellstreifen
- 4: Rückseite der Blende
- 5: Leiterplatte
- 6: Sensorfläche
- 7: elektronisches Bauelement
- 8: elektronisches Bauelement
- 9: elektrische Verbindung zur Geräteelektronik
- 10: Halterung der Leiterplatte
- 11: Druckfeder
- 12: Druckfeder
- 13: Elektronikgehäuseboden
- 14: Dichtung
- 15: Vergussmasse
- 16: Durchbruch
- 17: Hohlraum
- 18, 18': Teilfläche der Sensorfläche
- 19, 19': Teilfläche der Sensorfläche
- 20: Berührposition
- 21 i: Querstreifen (i=1,...,9)
- 22i: ersten Abschnitt der Querstreifen (i=1,...,9)
- 22: Sensorbereich
- 23i: zweiter Abschnitt der Querstreifen (i=1,...,9)
- 23: Betätigungsbereich
- 24: Abhebesensorfläche
- 25: Testquerstreifen
- 26: Endsensorfläche
- 27: Endsensorfläche
- 28: sensorische Fläche einer Sensortaste
- 29: sensorische Fläche einer Sensortaste
- 30: Abschirmfläche
- 31: niederohmiger Widerstand
- 32: Taktsignal
- 33j: Querstreifen (j=1,...,4)
- 34m: erste Querstreifen (m=1,...,52)
- 35m: zweite Querstreifen (m=1,...,52)
- 41: erste Schicht
- 42: zweite Schicht
- 43: dritte Schicht
- 44: vierte Schicht
- 45: erste Isolierschicht
- 46: zweite Isolierschicht
- 47: dritte Isolierschicht
- 51: erster Kondensator
- 52: zweiter Kondensator
- 521: erster Teil des zweiten Kondensators
- 522: zweiter Teil des zweiten Kondensators
- 53: dritter Kondensator
- b: Breite eines Querstreifens
- l: Länge eines Querstreifens
- a: Abstand zwischen zwei benachbarten Querstreifen
- α: Winkel

## Patentansprüche

1. Kapazitiver Stellstreifen, der zumindest eine von einem Dielektrikum (2) abgedeckte elektrisch leitfähige Sensorfläche (6) aufweist, die Teil eines Kondensators (51, 52) mit durch Berührung des Stellstreifens (3) innerhalb eines Betätigungsbereichs (23) veränderlicher Kapazität ist, wobei eine Kapazitätsänderung des Kondensators (51, 52) bei Berührung innerhalb des Betätigungsbereichs (23) von der Berührungsposition (20) längs des Stellstreifens (3) abhängig ist, wobei längs des Stellstreifens (3) galvanisch isoliert zu der Sensorfläche (6) und galvanisch isoliert zueinander eine Vielzahl von elektrisch leitfähigen Querstreifen (211 bis 219) nebeneinander angeordnet sind, die zumindest die Sensorfläche (6) in ihrer Ausdehnung quer zu dem Stellstreifen (3) überdecken, wobei die Querstreifen (211 bis 219) mit jeweils einem ersten Abschnitt (221 bis 229) die Sensorfläche (6) überdecken und einen Sensorbereich (22) des Stellstreifens (3) bilden, wobei sich die Querstreifen (211 bis 219) mit jeweils einem zweiten Abschnitt (231 bis 239) auf zumindest einer Seite quer zu dem Stellstreifen (3) über die Sensorfläche (6) hinaus erstrecken, und wobei die Querstreifen (211 bis 219) zumindest mit ihrem zweiten Abschnitt (231 bis 239) den Betätigungsbereich (23) des Stellstreifens (3) bilden, **dadurch gekennzeichnet, dass** die Querstreifen (211 bis 219) derart abgewinkelt sind, dass der Sensorbereich (22) des Stellstreifens (3) in einer ersten Ebene liegt, und dass der Betätigungsbereich (23) des Stellstreifens (3) in einer zu der ersten Ebene unter einem Winkel (α) angeordneten zweiten Ebene liegt.

2. Stellstreifen nach Anspruch 1, **dadurch gekennzeichnet, dass** die Querstreifen (211 bis 219) und die Sensorfläche (6) in übereinanderliegenden Schichten (41, 42, 43, 44) auf einem gemeinsamen Trägermedium (2, 5) angeordnet sind oder gemeinsam eine selbsttragende Baugruppe bilden, und dass die jeweils aufeinanderfolgenden Schichten (41, 42, 43, 44) voneinander galvanisch isoliert sind.

3. Stellstreifen nach Anspruch 2, **dadurch gekennzeichnet, dass** die Baugruppe eine mehrlagige Leiterplatte (5) ist, bei der die Schichten (41, 42, 43, 44) auf verschiedenen Lagen aufgebracht sind.

4. Stellstreifen nach Anspruch 2 oder 3, **dadurch gekennzeichnet, dass** in einer ersten Schicht (41) erste Querstreifen (34m; m=1 bis 52) angeordnet sind, dass in einer zweiten Schicht (42) unterhalb der ersten Schicht (41) die Sensorfläche (6, 18, 19) angeordnet ist, dass in einer dritten Schicht (43) unterhalb der zweiten Schicht (42) zweite Querstreifen (35m; m=1 bis 52) angeordnet sind, und dass jeder der zweiten Querstreifen (35m; m=1 bis 52) mit je einem unmittelbar darüber liegenden ersten Querstreifen (34m; m=1 bis 52) galvanisch leitfähig verbunden ist.

5. Stellstreifen nach einem der vorhergehenden Ansprüche, **dadurch gekennzeichnet, dass** der Stellstreifen (3) geradlinig oder bogenförmig oder ringförmig ausgebildet ist.

6. Stellstreifen nach einem der vorhergehenden Ansprüche, **dadurch gekennzeichnet, dass** der Stellstreifen (3) gegenüber Feuchtigkeit abgedichtet ist.

7. Eingabefeld für ein Haushaltsgerät mit zumindest einem Stellstreifen (3) nach einem der Ansprüche 1 bis 6.

8. Haushaltgerät mit einem Eingabefeld (1) nach Anspruch 7.

9. Glaskeramikkochfeld mit zumindest einem Stellstreifen (3) nach einem der Ansprüche 1 bis 6.
